# EUROPEAN PATENT APPLICATION

(11) **EP 2 075 825 A1**
(43) Date of publication of application: **01.07.2009**
(21) Application number: 08150920.0
(22) Date of filing: 31.01.2008
(51) Int. Cl.: H01L 21/321, H01L 21/768

(54) **semiconductor device comprising conductive structures and a planarized surface**

(30) Priority: 28.12.2007 US 017271
(71) Applicant: Interuniversitair Microelectronica Centrum vzw (IMEC), 3001 Leuven (BE)
(72) Inventor: Swinnen, Bart, 3220, Holsbeek (BE); Ruythooren, Wouter, 3150, Tildonk (BE); Beyne, Eric, 3001, Leuven (BE)
(74) Representative: Hertoghe, Kris Angèle Louisa

(57) **Abstract**

The present invention provides a method for forming a semiconductor device comprising conductive structures. The method comprises, on a major surface (20a) of a substrate (20), the major surface lying in a plane, obtaining a layer of conductive material (23) at least partly filling at least one opening (22) in a patterned dielectric layer (21) on the major surface (20a) of the substrate (20) and at least removing part of the patterned dielectric layer (21) by cutting the patterned dielectric layer (21) to a predetermined height in a direction substantially parallel to the plane of the major surface (20a) of the substrate (20). The present invention also provides semiconductor devices thus obtained. The semiconductor devices have at least a patterned dielectric layer (21) with a substantially flat surface may comprise at least one conductive structure having sizes of higher than 2 µm.

## Description

### Technical field of the invention

The present invention relates to semiconductor devices. More particularly, the present invention relates to semiconductor devices comprising conductive structures and a planarized surface, and to methods for obtaining such semiconductor devices.

### Background of the invention

A typical technique for providing a back-end of line (BEOL) or interconnect structure on semiconductor chips is a so-called damascene process. The damascene process can be described as a process in which interconnect metal lines are delineated in dielectrics thereby isolating them from each other. In this process, first an interconnect pattern comprising trenches is lithographically defined in the layer of dielectric material, then metal is deposited to fill the trenches and then excess metal is removed by means of chemical-mechanical polishing (CMP, planarization).

Basically two damascene processes exist, namely a single-damascene and a dual-damascene process.
A single damascene process typically comprises the steps of forming a pattern in a dielectric layer, e.g. a silicon oxide layer, thereby providing openings in the dielectric layer, providing a seed layer on top of the patterned dielectric layer (including on the sidewalls and on the bottom of the openings), filling these openings with a conductive interconnect material by plating, e.g. with a metal, and removing the excess conductive material, e.g. metal, on the wafer surface by CMP thereby leaving inlaid interconnect features on the substrate.

A dual damascene process can be described as a modified version of the single damascene process in which two interlayer dielectric patterning steps, one seed layer deposition step and one CMP step create a pattern which would require two patterning steps, two seed layer deposition steps and two metal CMP steps when using the single damascene process.

Details of damascene processes are described in "Making the move to dual damascene processing" by P. Singer in Semiconductor International 20, 79-82, 1997.

A disadvantage of a damascene process is that it requires CMP techniques to planarise the dielectric layer and the conductive layers, e.g. metal layers. A disadvantage thereof is that CMP cannot be used for large devices, e.g. devices comprising metal interconnect features having, for example, sizes (e.g. diameters or widths) of larger than 2 µm, for example larger than 3 µm, larger than 5 µm, larger than 10 µm. When using CMP on devices having such large sizes, this may not lead to sufficiently planar surfaces, but may lead to surfaces showing irregularities, for example by the effects of what is known in the art as dishing. Dishing is a phenomenon that will always occur, i.e. also for smaller sizes, but its effect is smaller for smaller sizes. A technique exists in the art which aims at reducing the dishing effect by providing metal or dielectric dummies e.g. next to the functional features, but this technique cannot completely remove the dishing effect and still provides a burden because of the extra processing and design complexity.

Another disadvantage of the CMP process is that it is practically limited to the removal of thin layers, since thinning time is a function of the thickness of the layer and thinning occurs relatively slowly.

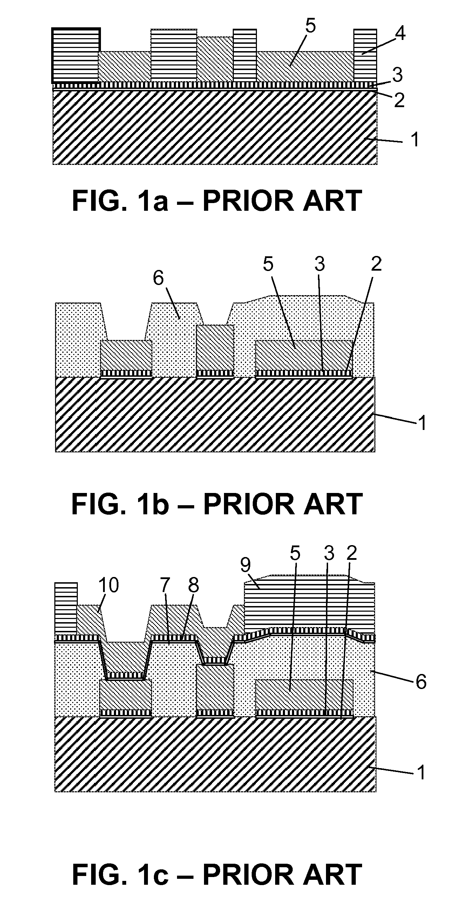

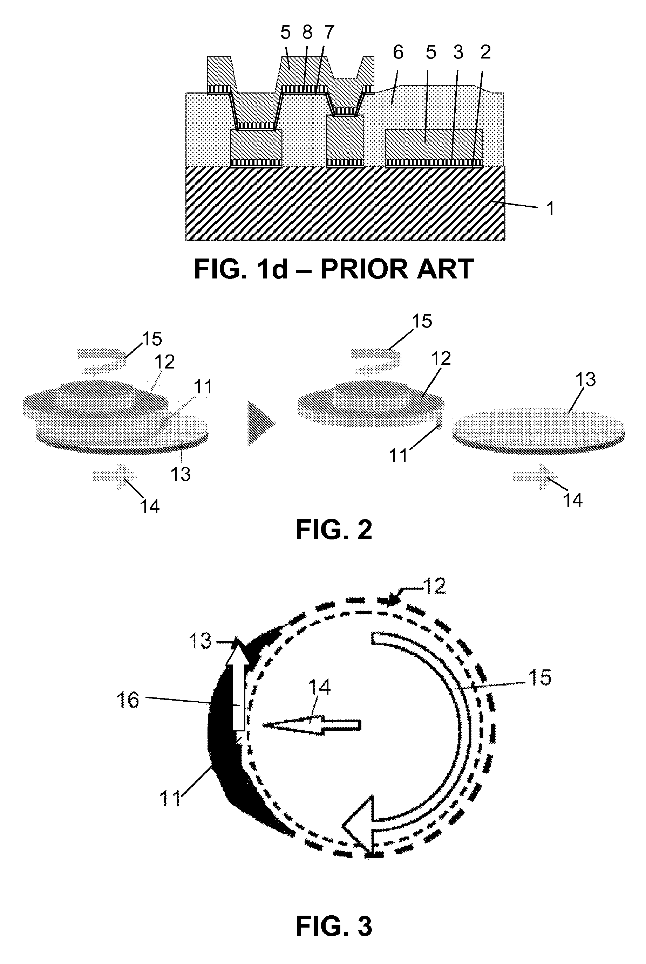

When processing a thin film substrate comprising interconnect structures which typically occurs at larger dimensions or scales than providing the back-end of line or interconnect structure on semiconductor chips, for instance at metal feature dimensions (e.g. diameters or widths) of larger than 2 µm, for example larger than 3 µm, larger than 5 µm, or larger than 10 µm, typically a Through Mask Plating Process (TMP) may be used. A TMP process for creating interconnect structures on a substrate is illustrated in Figs. 1a to 1d. In a first step, onto a substrate 1 a first liner 2 is provided onto which a first seed layer 3 is then provided, e.g. sputtered. Then, a first patterned resist layer 4 is provided. The first patterned resist layer 4 comprises openings which are then filled with conductive material, e.g. by electroplating of copper 5, to form interconnection lines. This is illustrated in Fig. 1a. The first patterned photoresist layer 4 is then removed. At the same time the first liner 2 and first seed layer 3 are also removed at locations where no copper is electroplated. In a next step, which is illustrated in Fig. 1b, a layer of a dielectric material 6, e.g. BCB (benzo-cyclo butane) is provided and patterned. The sequence of steps as described above can, if required, be repeated to create more levels of interconnecting lines. Therefore, a second liner 7 and a second seed layer 8 are provided as illustrated in Fig. 1c. A second patterned resist layer 9 is provided and a conductive material is provided, e.g. copper 10 is electroplated. The second patterned resist layer 9 is then removed, together with the second liner 7 and second seed layer 8 (see Fig. 1d).

A disadvantage of such TMP process is that a resist layer needs to be first applied and removed afterwards, and that a seed layer etch is necessary. Hence, the TMP process comprises many process steps and a certain degree of topography is introduced. There may also be issues with getting a sufficient plating uniformity, which is linked with the topography issue. The thickness of the plating process is determined by at least the densities of the patterns to be plated and the dimensions of those patterns. This may result in different thicknesses at different locations on the substrate, as is for instance also illustrated in Fig .1d.

### Summary of the invention

It is an object of embodiments of the present invention to provide a good method for forming semiconductor devices comprising interconnection structures, as well as to provide reliable semiconductor devices comprising interconnection structures.

The above objective is accomplished by a method and device according to the present invention.

A method according to embodiments of the invention requires less process steps than prior art methods.

A method according to embodiments of the invention does not introduce an increase of topography on the substrate.

A further advantage of the method according to embodiments of the invention is that thick layers with a thickness of between 1 and 100 microns, more preferably with a thickness of between 1 and 10 microns can be removed in a limited number of passes of the diamond bit over the surface of the structure. Another advantage of the method according to embodiments of the invention is that it can advantageously be used for forming semiconductor devices having sizes, e.g. diameters or widths, larger than 2 µm, larger than 3 µm, larger than 5 µm or larger than 10 µm.

In a first aspect, the present invention provides a method for forming a semiconductor device comprising conductive structures on a substrate, the substrate having a major surface lying in a plane. The method comprises:
a) obtaining a layer of conductive material at least partly filling at least one opening in a patterned dielectric layer on the major surface of the substrate, and
b) at least removing part of the patterned dielectric layer by cutting the patterned dielectric layer to a predetermined height in a direction substantially parallel to the plane of the major surface of the substrate.

According to embodiments of the invention, the method may furthermore comprise removing part of the conductive material while cutting the patterned dielectric layer to the predetermined height.

It is an advantage of a method according to embodiments of the present invention that it does not require the use of a mask such as e.g. a resist for obtaining discrete features of conductive material, there is no increase of topography on the substrate and no care has to be taken with respect to uniformity of the layer of conductive material upon application thereof. A further advantage of a method according to embodiments of the invention is that the number of processing steps may be reduced with respect to prior art methods. Still a further advantage of a method according to embodiments of the invention is that thick layers with a thickness of between 1 and 100 micron can be removed in a limited number of passes. For example, thick layers with a thickness of between 1 µm and 100 µm can be removed with 1 or 2 or 3 or 4 or 5 passes of the diamond bit 11 over the surface of the structure. However, according to other embodiments, thick layers with a thickness of between 1 µm and 100 µm may also be removed with more than 5 passes of the diamond bit 11 over the surface of the structure.

Obtaining a layer of conductive material at least partly filling at least one opening in a patterned dielectric layer may comprise:
- providing on the major surface of the substrate a patterned dielectric layer having at least one opening, and
- providing a layer of conductive material to at least partly fill the at least one opening in the patterned dielectric layer.

The present invention also provides a method for forming a semiconductor device comprising conductive structures on a substrate, the substrate having a major surface lying in a plane. The method comprises:
a) obtaining a layer of conductive material filling at least one opening in a patterned dielectric layer on the major surface of the substrate, and
b) removing part of the patterned dielectric layer and the conductive material by cutting the patterned dielectric layer and the conductive material to a predetermined height in a direction substantially parallel to the plane of the major surface of the substrate.

The predetermined height in embodiments of the present invention may be such that, after cutting, the at least one opening in the patterned dielectric layer is substantially completely filled with conductive material.

An advantage hereof is that after cutting a substantially flat surface is obtained on which further processing may easily be performed. No increase of topography.

According to other embodiments, the predetermined height may be such that, after cutting, the at least one opening in the patterned dielectric layer is partly filled with conductive material.

The semiconductor device may comprise conductive, e.g. metal, structures such as e.g. interconnect structures, having sizes, e.g. diameter or width larger than 2 µm, for example larger than 3 µm, larger than 5 µm or larger than 10 µm. For example, the sizes, e.g. diameter or width may be between 2 µm and 100 µm, for example between 3 µm and 100 µm, between 5 µm and 100 µm or between 10 µm and 100 µm; size is e.g. diameter or width.

According to embodiments of the invention, providing a layer of conductive material may be performed by electroplating.

The method may furthermore comprise, before providing a layer of conductive material, providing a seed layer in the at least one opening for facilitating electroplating of the conductive material.

Before providing a seed layer in the at least one opening the method may furthermore comprise providing a liner in the at least one opening for preventing diffusion of the material of the seed layer and of the conductive material into the substrate.

Because the liner and/or seed layer are provided in the at least one opening in the dielectric material rather than before applying the dielectric material, removal of these materials is not required and thus seed layer etching is avoided.

Providing a patterned dielectric layer may be performed by:
- providing a layer of a dielectric material on the major surface of the substrate,
- providing a photoresist and developing the photoresist according to a predetermined pattern, and
- patterning the dielectric layer according to the predetermined pattern.

Providing a layer of dielectric material may be performed such that it does not comprise providing dummy structures in the layer of dielectric material.

According to embodiments of the invention, the method may furthermore comprise repeating steps a) and b) at least once.

An advantage hereof is that at least two interconnection levels can be created without increasing topography.

The method may furthermore comprise, before providing the layer of conductive material, providing a further patterned dielectric layer with at least one opening larger than and substantially coinciding with the at least one opening in the patterned dielectric layer.

With the openings in the further dielectric layer substantially completely coinciding with the at least one opening in the patterned dielectric layer is meant that the further dielectric layer does not substantially cover the at least one opening in the patterned dielectric layer. An advantage hereof is that two interconnection levels can be created in only one planarization step, i.e. only requiring one cutting step.

Providing a further patterned dielectric layer may comprise:
- optionally filling the at least one opening in the patterned dielectric layer with a sacrificial material,
- providing a further dielectric layer on the patterned dielectric layer,
- providing a photoresist and developing the photoresist according to a predetermined pattern,
- patterning the further dielectric layer according to the predetermined pattern, and
- if present, removing the sacrificial material from the at least one opening in the patterned dielectric layer.

According to embodiments of the invention, the sacrificial material and the material of the further dielectric layer may be the same.

According to embodiments of the invention, the conductive structures may be interconnection lines.

Cutting the patterned dielectric layer and the conductive material to a predetermined height may be performed by a surface planer DFS8910 obtainable from Disco Corporation, Japan.

In a further aspect, the present invention provides the use of the method according to embodiments of the invention for forming interconnection lines on a substrate.

The present invention also provides the use of a surface planer DFS8910 obtainable from Disco Corporation, Japan for performing a method according to embodiments of the present invention.

In a further aspect, a semiconductor device formed by the method according to embodiments of the present invention is provided.

The present invention also provides a semiconductor device comprising:
- at least one patterned dielectric layer on a substrate, the at least one patterned dielectric layer comprising a surface and at least one opening interrupting the surface, and
- a conductive material at least partly filling the at least one opening, the conductive material forming a conductive structure laid in the substrate, and wherein the surface of the patterned dielectric layer is substantially flat.

With substantially flat is meant that the surface of the dielectric layer has a thickness variation of less than 2 µm, for example less than 1 µm, less than 0.5 µm or less than 100 nm.

The present invention also provides a semiconductor device comprising:
- at least one patterned dielectric layer on a substrate, the at least one patterned dielectric layer comprising at least one opening, and
- a conductive material filling the at least one opening, the conductive material forming a conductive structure laid in the substrate,
and wherein the semiconductor device has a substantially flat surface.

With a substantially flat surface is meant that the surface has a thickness variation of less than 2 µm, for example less than 1 µm, less than 0.5 µm or less than 100 nm.

The semiconductor device may have at least one conductive structure with a dimension, e.g. diameter or width, larger than 2 µm, for example larger than 3 µm, larger than 5 µm or larger than 10 µm. For example, the semiconductor device may have at least one conductive structure with a dimension, e.g. diameter or width, between 2 µm and 100 µm, for example between 3 µm and 100 µm, between 5 µm and 100 µm or between 10 µm and 100 µm.

The conductive structures may be interconnection lines.

Particular and preferred aspects of the invention are set out in the accompanying independent and dependent claims. Features from the dependent claims may be combined with features of the independent claims and with features of other dependent claims as appropriate and not merely as explicitly set out in the claims.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

### Brief description of the drawings

Figs. 1a to 1d illustrate subsequent steps in a Through Mask Plating (TMP) process according to the prior art.
Fig. 2 and Fig. 3 illustrate a part of a fully automatic surface planer DFS8910 obtainable from Disco Corporation, Japan, which can be used with embodiments of the present invention.
Fig. 4 illustrates the principle of a bump planarization method according to the prior art and performed by a fully automatic surface planer DFS8910 obtainable from Disco Corporation, Japan.
Fig. 5a to 5c illustrate subsequent steps in a bump planarization method according to the prior art and performed by a fully automatic surface planer DFS8910 obtainable from Disco Corporation, Japan.
Fig. 6a to 6e illustrate subsequent steps of a method according to a first embodiments of the present invention.
Fig. 7a to 7c illustrate subsequent steps of a method according to a further embodiment of the present invention.
Fig. 8 illustrates a device comprising different interconnect levels formed with a method according to embodiments of the present invention.

In the different figures, the same reference signs refer to the same or analogous elements.

### Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, over, and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

The invention will now be described by a detailed description of several embodiments of the invention. It is clear that other embodiments of the invention can be configured according to the knowledge of persons skilled in the art without departing from the technical teaching of the invention, the invention being limited only by the terms of the appended claims.

In one aspect, the present invention provides a method for forming a semiconductor device comprising conductive structures, e.g. interconnection structures or interconnection lines, on a substrate, the substrate having a major surface lying in a plane. The method comprises:
a) obtaining a layer of conductive material at least partly filling at least one opening in a patterned dielectric layer on the major surface of the substrate, and
b) at least removing part of the patterned dielectric layer by cutting the patterned dielectric layer to a predetermined height in a direction substantially parallel to the plane of the major surface of the substrate. According to embodiments of the invention, the method may furthermore comprise removing part of the conductive material while cutting the patterned dielectric layer to the predetermined height.

An advantage of the method according to embodiments of the present invention is that no mask such as for instance a resist is required when obtaining, e.g. providing, the layer of conductive material. Furthermore, no uniformity is required in the provision of conductive material to form the conductive structures, e.g. interconnection lines. Nevertheless, the method according to embodiments of the invention does not introduce an increase, and most often provides a decrease, of topography on the substrate. The method according to embodiments of the invention can be used to make semiconductor devices having conductive structures with sizes, e.g. diameters or widths, larger than 2 µm, for example larger than 3 µm, larger than 5 µm or larger than 10 µm. For example, the method according to embodiments of the invention can be used to make semiconductor devices having conductive structures with sizes, e.g. diameters or widths, of between 2 µm and 100 µm, for example between 3 µm and 100 µm, between 5 µm and 100 µm or between 10 µm and 100 µm. Moreover, the method according to embodiments of the invention may require fewer processing steps than prior art methods, which is an advantage with respect to processing time and consequently processing costs.

Obtaining a layer of conductive material filling at least one opening in a patterned dielectric layer may comprise
providing on the major surface of the substrate a patterned dielectric layer having at least one opening, and
providing a layer of conductive material to fill the at least one opening in the patterned dielectric layer.

According to embodiments of the invention, the method for forming a semiconductor device comprising conductive structures, e.g. interconnection lines may be performed by a surface planer, such as a fully automatic surface planer DFS891 0 obtainable from Disco Corporation, Japan.

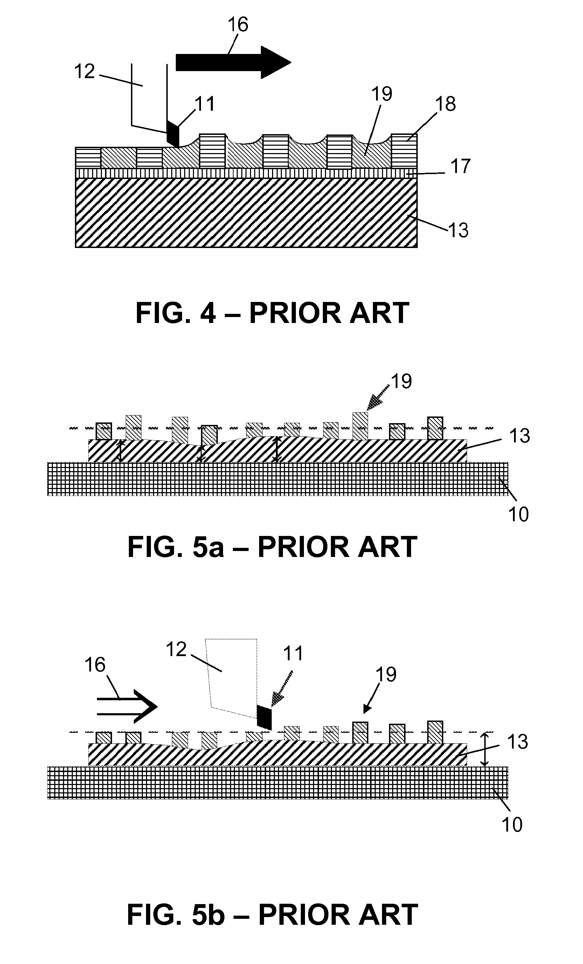

Up till now, such fully automatic surface planer DFS8910 has been used for performing bump planarization. The fully automatic surface planer DFS8910 lowers connection defects by planarizing bump structures formed on a substrate and makes the bump structures dimpleless. The fully automatic surface planer DFS8910 attains high-level planarization. The process performed with this fully automatic surface planer DFS8910 is also referred to as fly-cutting or diamond bit cutting. Part of such a fully automatic surface planer DFS8910 is illustrated in Fig.2 (taken from the website "http://www.discousa.com/eg/products/description/description15.html") and Fig. 3 (taken from K. Arai, A. Kawai, M. Mizukoshi, H. Uchimura, "A new planarization technique by high precision diamond cutting for packaging", International Symposium on Semiconductor Manufacturing (ISSM), Proceedings, 534-537, Tokyo, 27-29 September 2004). The surface planer DFS8910 rotates a single crystal diamond bit 11 which is attached to a spindle or wheel 12 at a designated cutting height and performs highly accurate planarization by feeding a wafer 13 from the side (indicated by arrow 14 in Figs. 2 and 3). After the wafer 13 is fed into the surface planer DFS8910, the wafer 13 is vacuumed down to a chuck table and cut with the diamond bit 11 while the latter is rotating at high speed (indicated by arrow 15 in Fig. 2 and Fig. 3), i.e. at a speed of for example 5000 rpm. The cutting direction 16 is in Fig. 3 indicated with arrow 16. The bump planarization method performed with the surface planer DFS8910 as described above will be described hereinafter with reference to Fig. 4 (see also K. Arai, A. Kawai, M. Mizukoshi, H. Uchimura, "A new planarization technique by high precision diamond cutting for packaging", International Symposium on Semiconductor Manufacturing (ISSM), Proceedings, 534-537, Tokyo, 27-29 September 2004). Bump structures 19 are created on the wafer 13. Therefore, on the wafer 13 a layer 17 is provided. Layer 17 can for instance be a seed layer but may be any other layer previously applied onto the wafer 13 or part of the wafer 13. Then a resist pattern 18 is provided of which openings present in the pattern 18 are filled with conductive material, e.g. metal provided by electroplating. With the bump planarization method a resist pattern 18 and bump structures 19 are then processed, i.e. planarized, using the single crystal diamond bit 11. The resist pattern 18 and bump structures 19 are cut by the diamond bit 11 in a direction indicated by arrow 16 in Fig. 4.

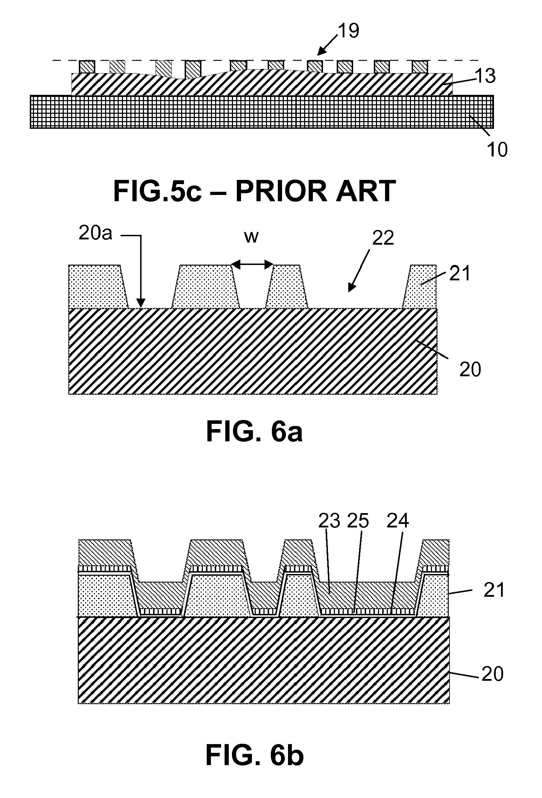

A processing sequence of the method described above is illustrated in Fig. 5a to 5c. A substrate 13 comprising bump structures 19 is provided on a chuck table 10 in the surface planer DFS8910 (see Fig. 5a). Then, the bump structures 19 are planarized using the diamond bit 11 (see Fig. 5b). The cutting direction is indicated by arrow 16. The spindle 12 with attached thereto the diamond bit 11 is fixed at a predetermined distance from the chuck table 10. By cutting the bump structures 19, the bump structures 19 are planarized and variations in wafer thickness can be corrected for in this way (see Fig. 5c), resulting in a planar surface of the device.

The fully automatic surface planer DFS8910 as described above can be advantageously used with a method according to embodiments of the present invention. Hereinafter, the method according to the present invention will be described by using such fully automatic surface planer. It has to be understood that this is only by way of an example and that any tool which is able to cut the patterned dielectric layer and the conductive material to a predetermined height may be used with the method according to embodiments of the present invention. Furthermore, hereinafter the method will be illustrated with reference to Fig. 6a to Fig. 6e. Again, this is only by way of an example and is not intended to limit the invention in any way.

In a first step, a substrate 20 is provided. In embodiments of the present invention, the term "substrate" may include any underlying material or materials that may be used, or upon which a device, a circuit or an epitaxial layer may be formed. In other alternative embodiments, this "substrate" may include a semiconductor substrate such as e.g. a doped silicon, a gallium arsenide (GaAs), a gallium arsenide phosphide (GaAsP), an indium phosphide (InP), a germanium (Ge), a silicon germanium (SiGe) substrate, a quartz or a glass substrate. The "substrate" may include for example, an insulating layer such as a SiO₂ or an Si₃N₄ layer in addition to a semiconductor substrate portion. Thus, the term substrate also includes silicon-on-glass, silicon-on sapphire substrates. The term "substrate" is thus used to define generally the elements for layers that underlie a layer or portions of interest. Also, the "substrate" may be any other base on which a layer is formed, for example a glass or metal layer. The substrate 20 may optionally be planarised. This may be done by for example depositing a planarisation layer of a photoresist, which may for example be an epoxy- or novolac-based polymer, onto the substrate.

Next, a patterned layer 21 of dielectric material may be provided onto the substrate 20, also referred to as patterned dielectric layer 21 (see Fig. 6a). This may, for example, be done as follows. First a layer of dielectric material may be provided onto a major surface 20a of the substrate 20. The dielectric material may be any suitable dielectric material known by a person skilled in the art, such as e.g. BCB (benzo-cyclo butane), or another polymer dielectric material, e.g. spin-on polymer dielectric material. Then a resist layer may be provided onto the layer of dielectric material, and this resist layer may be patterned. Providing a resist pattern may be done according to any known technique, such as for example standard photolithography. The photolithography process comprises the following subsequent steps. First, a photoresist layer is applied on top of the dielectric material, e.g. by means of spincoating. The photoresist layer may for example have a thickness of a few µm and may be made of any suitable polymer that can be used as a photoresist, such as for example poly(vinyl cinnamate) or novolak-based polymers. Thereafter, a mask is applied and the photoresist layer is then illuminated through the mask e.g. by means of UV light. After illumination the photoresist is developed by which either the illuminated parts of the photoresist (positive resist) or the non-illuminated parts of the photoresist (negative resist) are removed, depending on which type of photoresist has been used. Patterning of the layer of dielectric material is then performed using the developed photoresist layer as a mask, after which the remaining parts of the photoresist layer are removed, typically by using an organic solvent. The patterned dielectric layer 21 comprises at least one opening 22. The minimum width w, also referred to as minimal feature size, of the at least one opening 22 is limited by the possibilities of dielectric patterning.

Alternatively, the patterned dielectric layer 21, and more generally, any patterned dielectric layer present according to embodiments of the present invention, may be produced differently, when, for example, the dielectric layer itself is photodefinable or photopatternable. This is for instance the case for photodefinable BCB. According to these alternative embodiments, the dielectric layer may be illuminated with a patterned light beam in order to define a removable or not removable part, corresponding to the structure to be patterned. According to these alternative embodiments there is no need for using a photoresist process.

In a next step, which is illustrated in Fig. 6b, at least the at least one opening 22 in the patterned dielectric layer 21 is filled with a conductive material 23. This may, for example, be done by electroplating. In this case, optionally, first a liner 24 and/or a seed layer 25 may be provided in the at least one hole 22. The liner 24 may serve for preventing diffusion of the material of the seed layer 25 and/or the conductive material 23 into the substrate 20. The seed layer 25 may serve to facilitate electroplating of the conductive material 23. The conductive material may be any suitable conductive material to form conductive structures, e.g. interconnection lines, on the substrate 20. For example, the conductive material 23 may be a metal such as e.g. copper or gold. The uniformity of the layer of conductive material 23 is not of importance, as is illustrated in Fig. 6b, as it will be removed later on anyway (see further). An advantage of the method according to embodiments of the invention is that, when a seed layer 25 is provided before electroplating, this seed layer 25 does, contrary to prior art damascene processing, not have to be partly removed underneath the dielectric material during processing, and thus seed layer etching may be avoided.

The different layers provided in the method according to embodiments of the invention may have a thickness of between few µm to 20 µm.

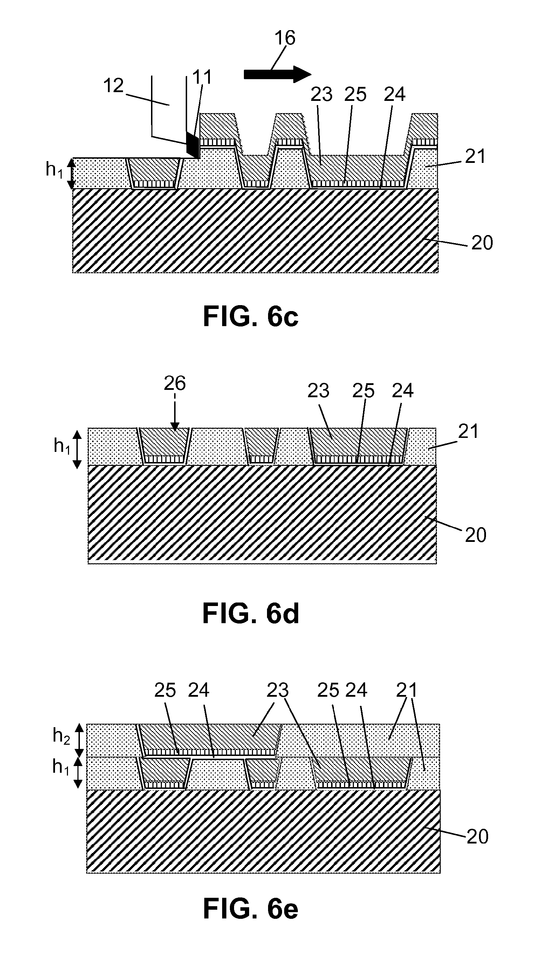

Next, part of the patterned dielectric layer 21 and part of the conductive material 23 are removed. This is done by cutting the patterned dielectric layer 21 and the conductive material 23 to a predetermined height h₁ in a direction substantially parallel to the plane of the major surface 20a of the substrate 20. This is illustrated in Fig. 6c. Cutting the patterned dielectric layer 21 and the conductive material 23 may be performed by a cutting device, such as for instance the surface planer DFS8910 as described above. The patterned dielectric layer 21 and the conductive material 23 may be cut by a cutter, a knife or a bit, e.g. the diamond bit 11 that is attached to the spindle 12. Cutting is performed in a direction substantially parallel to the plane of the major surface 20a of the substrate 20 as is indicated by arrow 16 in Fig. 6c. This cutting process may also be referred to as fly-cutting. The predetermined height h₁ may be such that after cutting the at least one opening 22 in the patterned dielectric layer 21 is substantially completely filled with conductive material 23 as can be seen from Fig. 6c (left part) and Fig. 6d. This leads to a device comprising conductive structures laid in the substrate 20 and having a substantially flat surface 26 (see Fig. 6d). For large devices, i.e. for devices with sizes, e.g. diameter or width, larger than 10 µm, for example between 10 µm and 100 µm, this is very difficult to obtain when using CMP, because of dishing occurring. The predetermined height h₁ depends on the required size, i.e. thickness of the conductive structures, e.g. interconnect lines.

According to other embodiments the height h₁ may be such that after cutting, the at least one opening 22 in the patterned dielectric layer 21 is only partly filled with conductive material, for example is filled for about one half or one third. As a result, the upper surface of the conductive structure may comprise some topography. The upper surface may comprise a substantially flat part, i.e. a part with a thickness variation of less than 2 µm, for example less than 1 µm, less than 0.5 µm or less than 100 nm, for example near sidewalls of the opening, and a non-flat part below the flat part, for example towards a centre of the opening. Such a structure may be substantially different from a structure showing dishing originating from CMP action. Furthermore, such a structure can within limits be "shaped" by controlling plating parameters, and may provide specific advantages; such as for instance a possibility to reduce the plating time. When the planarity of the upper surface of the conductive structure is not important or not required, this embodiment can advantageously be used. This can for instance, but not only, occur when producing the last interconnect layer of a stack of layers. Providing conductive material may in that case be done by processes other than plating processes; for example by directly sputtering a relatively thin layer, which can be seen as a relatively thick "seed layer" of conductive material in order to partially fill the openings 22, after which cutting can be performed as described earlier. With relatively thick seed layer is meant that the thickness of the seed layer is larger than the thickness of seed layers that are normally applied if they are required for facilitating plating of conductive materials to completely fill the holes, as was described above. This embodiment can be used for a single dielectric layer of a damascene stack or for both dielectric layers in a double damascene stack.

Then, the steps as described above may be repeated (see Fig. 6e). A second patterned dielectric layer 21 comprising at least one opening 22 may be deposited onto the structure as illustrated in Fig. 6d. Optionally a second liner 24 and a second seed layer 25 may be provided into the at least one opening 22. A second layer of conductive material 23 may then be provided, for example by electroplating. Then, part of the second patterned dielectric layer 21 and part of the second layer of conductive material 23 may be removed by cutting the second patterned dielectric layer 21 and the second conductive material 23 to a predetermined height h₂, as described above. Again, the predetermined height h₂ depends on the size of the conductive structure, e.g. interconnection line to be obtained. The predetermined height h₂ may be equal to the predetermined height h₁. In alternative embodiments, the predetermined height h₂ may be different from the predetermined height h₁.

As mentioned before, the openings in the second dielectric layer 21 may only be partly filled, and cutting can be performed similar to what has been described for the first dielectric layer 21.

The method according to the above-described embodiment is conceptually similar to a single damascene process used in CMOS processing but it relies on rather different materials, deposition and planarization techniques which makes it compatible with, for example, thin film processing for multi-chip modules (MCM), flip-chip interposer substrates and post-passivation processing of redistribution lines on top of CMOS circuitry. The method according to embodiments of the invention creates a similar structure as obtained by single damascene processing but in a different way. In the method according to embodiments of the invention dielectric patterning is performed first, followed by providing, e.g. electroplating, conductive material 23, e.g. metal and planarization. Optionally, before providing conductive material 23 a liner 24 and/or a seed layer 25 may be provided. In damascene processing, first the conductive material is provided and patterned and then a dielectric material is provided. In this case, when a liner and/or seed layer is provided before providing the conductive material, these layers have to be removed before providing the dielectric material. Hence, an advantage of the method according to embodiments of the invention is that it does not require provision and patterning of a resist to pattern the conductive material 23 and it does not require seed layer etching. These steps are time consuming and therefore increase the cost of the process. An advantage of the method according to embodiments of the invention is that thick layers with a thickness of between 1 µm and 100 µm can be removed with a limited number of passes of the diamond bit 11 over the surface of the structure. For example, thick layers with a thickness of between 1 µm and 100 µm can be removed with 1 or 2 or 3 or 4 or 5 passes of the diamond bit 11 over the surface of the structure. However, according to other embodiments, such thick layers with a thickness of between 1 µm and 100 µm may also be removed with more passes of the diamond bit 11 over the surface of the structure. This is different from a polishing process, e.g. CMP process, wherein two surfaces, i.e. the surface of the structure to be polished and the surface of the polishing means, are continuously in contact with each other for a longer period of time.

Furthermore, the method according to embodiments of the invention can be used for making devices with sizes, e.g. diameter or width, larger than 10 µm, for example with sizes, e.g. diameter or width, of between 10 µm and 100 µm.

Main advantages of a method according to embodiments of the present invention when compared to the Through Mask Plating process as known in the art may be that no resist has to be removed, that no or limited issues with plating uniformity appear, that a reduced topology is obtained, that it may require fewer process steps and that a seed-layer etch can be avoided.

Main differences between the method according to embodiments of the present invention and damascene processing as known in the art may be:
- planarization technique: in damascene processing CMP is used while in the method according to embodiments of the present invention fly-cutting is used.
- target application: damascene processing is mainly used in back-end of line CMOS processing while the method according to embodiments of the invention may be used for post-passivation redistribution and thin film processing.
- materials: in damascene processing low-k dielectrics are used while in the method according to embodiments of the invention any dielectric materials, for example spin-on polymer dielectric materials, can be used.
- layer thickness: damascene processing is limited to layer thicknesses of 1 µm and lower while in the method according to embodiments of the invention layer thicknesses can be used of between a few µm and 20 µm.
- feature sizes: damascene is typically applied for providing the back-end of line or interconnect structure on semiconductor chips for features with feature sizes, such as metal interconnect feature sizes, typically below 2 µm, or below 1 µm or below 0.5 µm. At this scale, dishing due to CMP also occurs but its effect can be kept relatively small. CMP processes can also be applied for larger feature sizes or surfaces, e.g. feature sizes of larger than 10 µm, but in order to limit dishing CMP should then be performed by using metal dummy techniques. The presence of e.g. a dummy layer slows down the removal of material from covered portions of the conductive layer and thereby prevents overpolishing which could otherwise cause dishing. The method according to embodiments of the present invention does not require application of such hard, e.g. metal, dummy techniques as compared to techniques in which CMP is used, as for instance damascene processes, which may be an advantage.

The method according to embodiments of the present invention may be extended to create two or more interconnection levels.

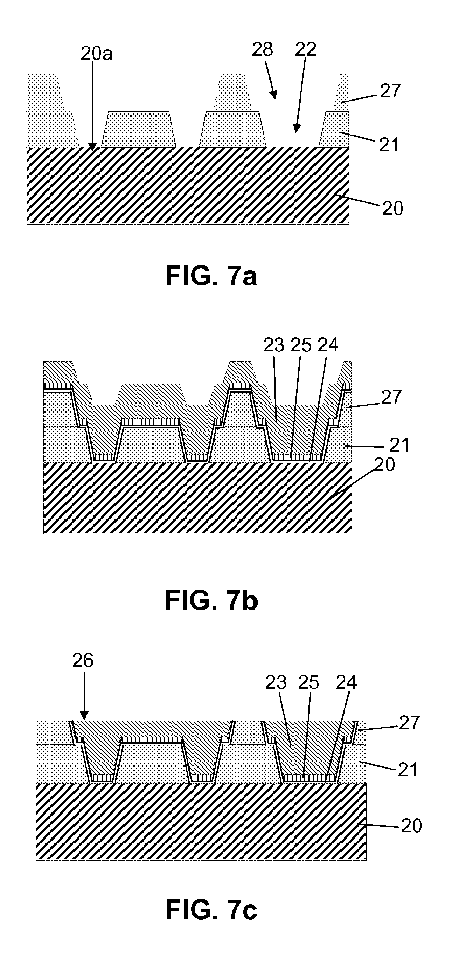

According to other embodiments, the method may furthermore comprise, before providing a layer of conductive material 23, providing a further patterned dielectric layer 27 with at least one opening 28, the at least one opening 28 being larger than and substantially completely coinciding with the at least one opening 22 in the first dielectric layer 21. An example of a process sequence according to these embodiments is illustrated in Figs. 7a to 7c.

In a first step, illustrated in Fig. 7a, a first patterned dielectric layer 21 may be provided on a major surface 20a of a substrate 20. The first patterned dielectric layer 21 comprises at least one opening 22. Providing the first patterned dielectric layer 21 may be done in a similar way as described in the above embodiment with respect to Fig. 6a. In a next step, a further patterned dielectric layer 27 may be provided on top of the first patterned dielectric layer 21. The further patterned dielectric layer 27 may comprise at least one opening 28. The at least one opening 28 in the further patterned dielectric layer 27 may be larger than and substantially completely coinciding with the at least one opening 22 in the first dielectric layer 21. With the openings 28 in the further dielectric layer 27 substantially completely coinciding with the at least one opening 22 in the first dielectric layer 21 is meant that the further dielectric layer 27 does not substantially cover the at least one opening 22 in the first dielectric layer 21.

Providing the further patterned dielectric layer 27 may, for example, be performed by:
- optionally filling the at least one opening 22 in the patterned dielectric layer 21 with a sacrificial material,
- providing a further dielectric layer onto the patterned dielectric layer 21,
- providing a photoresist and developing the photoresist according to a predetermined pattern, the predetermined pattern being such that the at least one opening 28 to be formed substantially completely coincides with the at least one opening 22 in the patterned dielectric layer 21, and is larger than this at least one opening 22,
- patterning the further dielectric layer according to the predetermined pattern, and
- in case of the presence of a sacrificial material, removing the sacrificial material from the at least one opening 22 in the patterned dielectric layer 21.

According to embodiments of the present invention, the sacrificial material may be the same material as the material of the further dielectric layer. According to these embodiments, the sacrificial material and the material of the further dielectric layer may both be applied simultaneously, i.e. in a single step.

In a next step, a conductive material 23 is provided for filling the at least one opening 22 in the first dielectric layer 21 and the at least one opening 28 in the further dielectric layer 27 (see Fig. 7b). Before providing the conductive material 23, a line 24 and/or a seed layer 25 may be provided over substantially the complete surface of the patterned dielectric layers, or at least in the formed openings 22, 28.

This is followed by removing part of the further dielectric material 27 and part of the conductive material 23. Removing part of the further dielectric material 27 and part of the conductive material 23 is done by cutting the further dielectric material 27 and the conductive material 23 to a predetermined height h₃. Cutting is performed in a direction substantially parallel to the plane of the major surface 20a of the substrate 20. After cutting, a device comprising conductive structures, e.g. interconnection lines and having a substantially flat surface 26 is obtained (see Fig. 7c).

The process according to the above embodiment is conceptually similar to a dual damascene processing but has the same main differences with damascene processing as described for the embodiment above. Furthermore, according to the present embodiment, only one planarization step, i.e. only one cutting step is required to form the same conductive structures as in the above described embodiment which required two cutting steps.

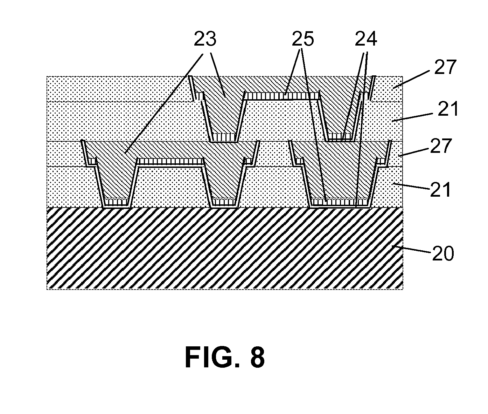

According to further embodiments of the invention, different interconnection levels can be provided in one device. This is illustrated in Fig. 8 for the device of which the method of fabrication is illustrated in Fig. 7a to 7c. It has to be noted that this is not intended to limit the invention in any way and that different interconnection levels may also be obtained with the method as described in the first embodiment with respect to Fig. 6a to 6e.

For forming a device as illustrated in Fig. 8, the process steps as described for the method illustrated in Fig. 7a to 7c may be repeated as many times as required. In the example given, these process steps are only repeated once. However, according to other embodiments and depending on the application required, the process steps may be repeated more than once.

Stacks of layers according to embodiment of the present invention may be produced, wherein different embodiments according to the present invention may be combined in different ways. Any combination of embodiments corresponding to Figs. 6a to 6e, embodiments according to Figs. 7a to 7c and embodiments according to Fig. 8 may be combined in a stack of layers.

It should furthermore be noted that with respect to Figs. 6a to 6e, Fig. 7a to 7c and Fig.8, whenever a seed layer is deposited and correspondingly depicted, this seed layer is also present on the sidewall of the openings, although to a lesser extent and depending on the slope of the sidewalls. It is therefore drawn very thin, corresponding to an embodiment of the invention.

The method according to embodiments of the invention provides good control of the thickness of the different layers. Because the method according to embodiments of the invention leads to devices with substantially flat surfaces 26, the method according to embodiments of the present invention may be used to form capacitor devices as materials further required can easily and reliably be provided on the obtained substantially flat surface 26, e.g. by spin-coating.

It is to be understood that although preferred embodiments, specific constructions and configurations, as well as materials, have been discussed herein for devices according to the present invention, various changes or modifications in form and detail may be made without departing from the scope of this invention as defined by the appended claims.

## Claims

1. A method for forming a semiconductor device comprising conductive structures on a substrate (20), the substrate (20) having a major surface (20a) lying in a plane, the method comprising:
a) obtaining a layer of conductive material (23) at least partly filling at least one opening (22) in a patterned dielectric layer (21) on the major surface (20a) of the substrate (20), and
b) at least removing part of the patterned dielectric layer (21) by cutting the patterned dielectric layer (21) to a predetermined height in a direction substantially parallel to the plane of the major surface (20a) of the substrate (20).

2. Method according to claim 1, furthermore comprising removing part of the conductive material (23) while cutting the patterned dielectric layer (21) to the predetermined height.

3. Method according to claim 1 or 2, wherein obtaining a layer of conductive material (23) at least partly filling at least one opening (22) in a patterned dielectric layer (21) comprises:
- providing on the major surface (20a) of the substrate (20) a patterned dielectric layer (21) having at least one opening (22), and
- providing a layer of conductive material (23) to at least partly fill the at least one opening (22) in the patterned dielectric layer (21).

4. Method according to any of the previous claims, wherein the predetermined height is such that, after cutting, the at least one opening (22) in the patterned dielectric layer (21) is substantially completely filled with conductive material (23).

5. Method according to any of claims 1 to 3, wherein the predetermined height is such that, after cutting, the at least one opening (22) in the patterned dielectric layer (21) is partly filled with conductive material (23).

6. Method according to any of the previous claims, wherein at least one of the conductive structure has sizes larger than 2 µm.

7. Method according to any of the previous claims, wherein providing a layer of conductive material (23) is performed by electroplating.

8. Method according to claim 7, wherein the method furthermore comprises, before providing a layer of conductive material (23), providing a seed layer (25) in the at least one opening (22).

9. Method according to claim 8, wherein the method furthermore comprises, before providing a seed layer (25) in the at least one opening (22), providing a liner (24) in the at least one opening (22).

10. Method according to any of the previous claims, wherein providing a patterned dielectric layer (21) is performed by:
- providing a layer of a dielectric material on the major surface (20a) of the substrate (20),
- providing a photoresist and developing the photoresist according to a predetermined pattern, and
- patterning the dielectric layer according to the predetermined pattern.

11. Method according to claim 10, wherein providing a layer of dielectric material does not comprise providing dummy structures in the layer of dielectric material.

12. Method according to any of the previous claims, wherein the method furthermore comprises repeating steps a) and b) at least once.

13. Method according to any of claims 3 to 11 in as far as dependent on claim 3, wherein the method furthermore comprises, before providing the layer of conductive material (23):
c) providing a further patterned dielectric layer (27) with at least one opening (28) larger than and substantially coinciding with the at least one opening (22) in the patterned dielectric layer (21).

14. Method according to claim 13, wherein the method furthermore comprises repeating steps a) to c) at least once.

15. Method according to any of the previous claims, wherein the conductive structures are interconnection lines.

16. Method according to any of the previous claims, wherein cutting the patterned dielectric layer (21) and the conductive material (23) to a predetermined height is performed by a surface planer DFS8910 obtainable from Disco Corporation, Japan.

17. Use of the method according to any of the previous claims for forming interconnection lines on a substrate.

18. Use of a surface planer DFS8910 obtainable from Disco Corporation, Japan for performing a method according to any of claims 1 to 15.

19. A semiconductor device formed by the method according to any of claims 1 to 16.

20. A semiconductor device comprising:
- at least one patterned dielectric layer (21, 27) on a substrate (20), the at least one patterned dielectric layer (21, 27) comprising a surface and at least one opening (22) interrupting the surface, and
- a conductive material (23) at least partly filling the at least one opening (22), the conductive material (23) forming a conductive structure laid in the substrate (20),
and wherein the surface of the patterned dielectric layer (21, 27) is substantially flat.

21. A semiconductor device according to claim 20, the at least one opening (22) being completely filled with conductive material (23), wherein the surface (26) of the semiconductor device is substantially flat.

22. A semiconductor device according to claim 20 or 21, wherein the semiconductor device has at least one conductive structure with a dimension larger than 2 µm.

23. A semiconductor device according to any of claims 20 to 22, wherein the conductive structures are interconnection lines.
